# FASCICULE DE BREVET EUROPEEN

(11) **EP 1 484 797 B1**
(45) Date de publication et mention de la délivrance du brevet: **15.04.2009**
(21) Numéro de dépôt: 04300311.0
(22) Date de dépôt: 02.06.2004
(51) Int. Cl.: H01L 25/11

(54) **Cellule de commutation de puissance, et procédé de fabrication de la cellule**
Leistungswechselrichter und dessen Herstellung
Inverter power device and method of making it

(30) Priorité: 04.06.2003 FR 0306748
(43) Date de publication de la demande: 08.12.2004
(73) Titulaire: ALSTOM Transport SA, 92300 Levallois-Perret (FR)
(72) Inventeur: Breit, Fabrice, 65710 Campan (FR); Lebey, Thierry, 31000 Toulouse (FR)

(56) Documents cités:
- EP-A- 1 162 719
- EP-A- 1 172 850
- EP-A- 1 318 547
- US-A- 5 574 312
- US-A- 6 060 795
- US-A1- 2003 090 873
- LEE T-Y: "DESIGN OPTIMIZATION OF AN INTEGRATED LIQUID-COOLED IGBT POWER MODULE USING CFD TECHNIQUE" IEEE TRANSACTIONS ON COMPONENTS AND PACKAGING TECHNOLOGIES, IEEE SERVICE CENTER, PISCATAWAY, NJ, US, vol. 23, no. 1, mars 2000 (2000-03), pages 55-60, XP000924185 ISSN: 1521-3331

## Description

L'invention concerne une cellule de commutation de puissance ainsi qu'un procédé de fabrication de cette cellule.

Plus précisément, l'invention concerne une cellule de commutation comportant :
- au moins deux composants de puissance présentant chacun une première face équipée d'au moins une borne de connexion électrique et une seconde face opposée équipée d'au moins une autre borne de connexion électrique ces composants formant une chaîne de composants électriquement raccordés en série par l'intermédiaire d'au moins une connexion intermédiaire chaque connexion intermédiaire reliant électriquement la seconde face du composant précédent à la première face du composant suivant dans ladite chaîne, et
- un substrat diélectrique à l'intérieur duquel sont incorporés lesdits au moins deux composants.

De telles cellules de commutation sont, par exemple, fréquemment utilisées pour réaliser des onduleurs destinés à alimenter des moteurs électriques utilisés pour la traction des trains. Dans de telles applications, la cellule de commutation doit être capable de commuter des courants supérieurs à mille ampères et de résister à des tensions supérieures à cinq mille volts. Pour atteindre de telles performances et notamment pour supporter de telles tensions, chaque cellule de commutation est réalisée à partir de plusieurs interrupteurs élémentaires tels que des transistors IGBT, raccordés les uns aux autres en série.

Par ailleurs, aujourd'hui, le CPES (Center for Power Electronics System (CPES), Virginia Tech., 657 Whittemore Hall (0111), Blacksburg, VA 24061) a divulgué un procédé pour incorporer des transistors travaillant à moins de 600 volts, à l'intérieur d'un substrat. Par exemple, dans l'article « Embedded Power-An Intégration Packaging technology for IPEMs » par les auteurs Zhenxian Liang, Fred C. Lee, and G.Q. Lu, dont on peut se procurer une copie auprès du CPES, un premier transistor IGBT1 et un second transistor IGBT2 raccordés en série sont tous les deux incorporés dans l'épaisseur d'une lame horizontale en matériau diélectrique. La face supérieure de chacun de ces transistors, équipée de bornes de connexion de grille et d'émetteur, est tournée vers le haut, tandis que la face inférieure, équipée d'une borne de connexion du collecteur, est tournée vers le bas. Pour raccorder ces deux transistors en série, il est donc nécessaire de raccorder électriquement, par exemple l'émetteur du transistor IGBT1 au collecteur du transistor IGBT2. Cette liaison est ici appelée connexion intermédiaire. Puisque l'émetteur du transistor IGBT1 est sur la face supérieure de la lame tandis que le collecteur du transistor IGBT2 est sur la face inférieure de la lame, cette liaison doit traverser le substrat. Il existe donc sur la face supérieure de la lame au moins deux potentiels différents Ve1 et Ve2 correspondant respectivement aux potentiels des émetteurs des transistors IGBT1 et IGBT2. De même, sur la face inférieure de la lame il existe également deux potentiels différents Vc1 et Vc2 correspondant respectivement aux potentiels des collecteurs des transistors IGBT1 et IGBT2. Puisque ces deux transistors sont raccordés en série, la tension Ve1 est égale à la tension Vc2.

La présence de différents potentiels sur la même face du substrat impose d'espacer les premier et second transistors l'un de l'autre d'une distance minimale d'isolation. En deçà de cette distance minimale d'isolation un court-circuit risque de s'établir entre ces deux potentiels, soit par claquage de l'air environnant, soit par cheminement à la surface du substrat. Cette distance d'isolation est donc fonction à la fois des propriétés diélectriques de l'air et de la valeur des différents potentiels.

Dès lors, lorsque l'on souhaite appliquer cette technologie pour réaliser des cellules de commutation de puissance capables de travailler sous des tensions de plusieurs milliers de volts, la distance minimale d'isolation à respecter augmente et l'encombrement de la cellule de commutation aussi. Ceci est un frein à l'application de l'enseignement de l'article du CPES au domaine des moyennes tensions.

Ainsi, l'invention vise à améliorer les techniques d'intégration de composants développées par le CPES de manière à pouvoir appliquer cette technologie à des composants de puissance dans le domaine des moyennes tensions.

L'invention a donc pour objet une cellule de commutation de puissance telle que décrite ci-dessus caractérisée :
- en ce que la ou chaque connexion intermédiaire ainsi que les faces des composants raccordées à cette connexion intermédiaire sont entièrement incorporées à l'intérieur dudit substrat, et
- en ce que les faces non raccordées à une connexion intermédiaire des composants situés aux extrémités de ladite chaîne sont disposées de manière à être séparées l'une de l'autre par l'intermédiaire du matériau diélectrique formant ledit substrat dans lequel ils sont incorporés. Les courts-circuits par cheminement à la surface du substrat n'existent donc plus.

Dans la cellule ci-dessus, le potentiel de chaque connexion intermédiaire est isolé des potentiels différents présents en d'autres points de la même chaîne par l'intermédiaire du matériau diélectrique formant le substrat dans lequel ces composants sont incorporés. Les courts-circuits par cheminement à la surface du substrat n'existent donc plus.

Ce matériau diélectrique présente une résistance au claquage supérieure à celle de l'air de sorte que la distance minimale à prévoir entre deux composants successifs de la dite chaîne peut être réduite. Dès lors, en incorporant en plus dans le substrat la connexion intermédiaire, il devient possible d'appliquer l'enseignement de l'article du CPES à des composants de puissance destinés à travailler dans les moyennes tensions tout en obtenant une cellule dont l'encombrement reste raisonnable.

Suivant d'autres caractéristiques d'une cellule conforme à la mention :
- les faces non raccordées à une connexion intermédiaire des composants situés aux extrémités de la dite chaîne sont tournées dans des directions différentes de manière à ce que le plus court chemin entre ces deux faces traverse le matériau diélectrique formant ledit substrat dans lequel ils sont incorporés ;
- le substrat est formé d'un empilement de lames parallèles en matériau diélectrique, et en ce que chacun des composants se suivant dans ladite chaîne est incorporé dans l'épaisseur d'une lame différente ;
- les première et seconde faces de chaque composant sont parallèles aux faces de la lame dans laquelle le composant est incorporé ;
- au moins l'une des première et seconde faces de chaque composant affleure d'un côté de la lame dans laquelle le composant est incorporé ;
- ladite connexion intermédiaire entre deux composants est formée par une piste électrique gravée sur au moins l'une des faces de la lame dans laquelle l'un de ces deux composants est incorporé ;
- au moins l'un des deux composants de ladite chaîne est soudé sur ladite piste électrique gravée ;
- elle comporte au moins un canal de circulation d'un fluide de refroidissement ménagé à l'intérieur dudit substrat pour refroidir au moins l'un des composants incorporés dans ce substrat ;
- elle comporte plusieurs canaux de circulation d'un fluide de refroidissement, et chaque composant de puissance est interposé entre au moins deux de ces canaux de manière à ce que sa première et sa seconde face soient refroidies par ces canaux ;
- elle comporte au moins un canal de circulation d'un fluide de refroidissement ménagé dans chaque lame formant ledit substrat ;
- ledit au moins un canal ménagé dans chaque lame est situé en dessous du ou de chaque composant soudé sur la face de cette lame ;
- le substrat présente au moins une première et une deuxième faces opposées ; la cellule comporte une languette de connexion électrique raccordée à la première face du premier composant, de ladite chaîne et une deuxième languette de connexion électrique raccordée à la seconde face du dernier composant de la dite chaîne, et les première et deuxième languettes sont en saillies respectivement sur les première et seconde faces opposées ;
- le substrat présente une troisième face différente des première et deuxième faces, la cellule comporte au moins une troisième languette de connexion électrique raccordée à une connexion intermédiaire et cette troisième languette est en saillie à partir de la troisième face ;
- les composants sont des transistors de puissance ; et
- le substrat est de forme parallélépipédique ;
- les lames incorporant les composants sont toutes de taille identique.

L'invention a également pour objet un procédé de fabrication d'une cellule de commutation conforme à l'invention, qui comporte :
- une phase de fabrication de blocs élémentaires, chaque bloc élémentaire étant formé d'une lame du substrat sur laquelle est soudé l'un des composants de puissance et dans laquelle est ménagé un trou traversant destiné à recevoir le composant de puissance d'un autre bloc élémentaire identique, et
- une phase d'assemblage lors de laquelle les blocs élémentaires sont empilés les uns sur les autres pour former ladite cellule de commutation.

Le document US2003/0090873 décrit une cellule de commutation comportant un empilement de plusieurs modules de puissance qui sont séparés l'un de l'autre par un espacement pour recevoir un liquide de refroidissement. Le dispositif selon la présente invention est avantageux par rapport à ce dispositif parce qu'il permet un plus grand degré d'intégration.

L'invention sera mieux comprise à la lecture de la description qui va suivre, donnée uniquement à titre d'exemple et faite en se référant aux dessins sur lesquels :
- la figure 1 est un schéma électrique d'une chaîne de trois composants de puissance,
- la figure 2 est une illustration schématique en perspective d'une cellule de commutation conforme à l'invention,
- les figures 3 et 4 sont des vues en coupe respectivement selon les lignes III-III et IV-IV de la cellule de commutation de la figure 2,
- la figure 5 est un organigramme d'un procédé de fabrication de la cellule de la figure 1,
- les figures 6A à 6F sont des illustrations schématiques de la cellule de la figure 2 à différents stades de fabrication.

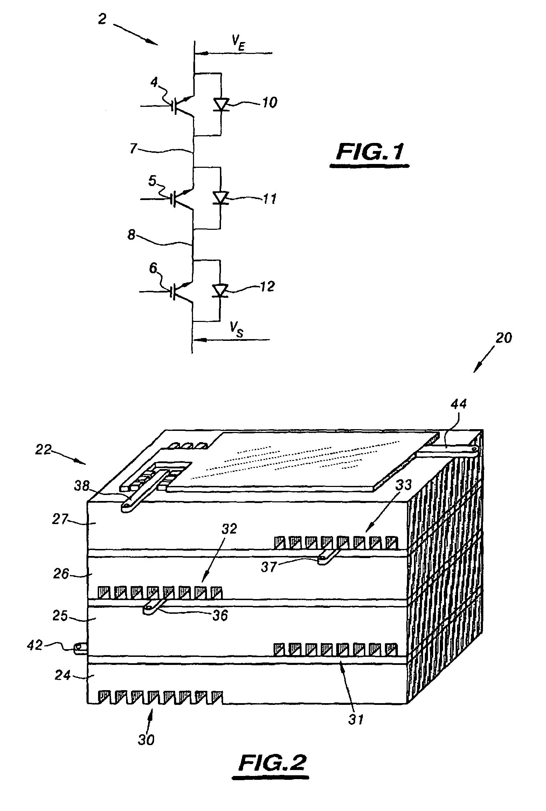

La figure 1 représente une chaîne 2 formée de trois transistors IGBT (Insulated Gate Bipolar Transistor) 4, 5 et 6 raccordés en série entre un potentiel d'entrée Ve et un potentiel de sortie Vs. L'émetteur du transistor 4 est raccordé au potentiel Ve tandis que le collecteur du transistor 6 est raccordé au potentiel Vs. Des connexions intermédiaires 7 et 8 raccordent directement, respectivement l'émetteur du transistor 5 au collecteur du transistor 4 et l'émetteur du transistor 6 au collecteur du transistor 5.

Trois diodes 10,11 et 12, sont raccordées chacune en position anti-parallèle aux bornes respectivement des transistors 4, 5 et 6. Cette chaîne correspond, par exemple, au schéma électrique d'une cellule de commutation destinée à former l'un des deux interrupteurs d'un des bras d'un onduleur triphasé propre à alimenter le moteur électrique de traction d'un train.

La figure 2 représente une cellule de commutation, désignée par la référence générale 20, correspondant au schéma électrique de la figure 1.

Cette cellule est formée d'un substrat 22 en matériau diélectrique de forme sensiblement parallélépipédique à l'intérieur duquel sont incorporés les transistors 4 à 6 et les diodes 10 à 12 de la figure 1. Le substrat 22 est formé par un empilement de 4 lames horizontales 24 à 27 en matériau diélectrique et thermiquement conducteur tel que de l'alumine, du nitrure d'aluminium ou du diamant. A l'intérieur de chaque lame 25 à 27 sont incorporés un transistor et sa diode anti-parallèle. Plus précisément, les lames 25, 26 et 27 incorporent respectivement le transistor 6 et sa diode 12, le transistor 5 et sa diode 11, et le transistor 4 et sa diode 10.

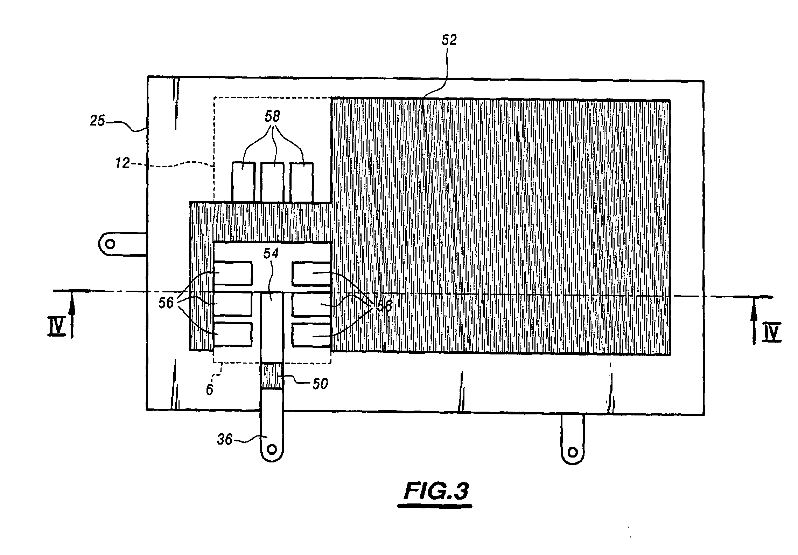

Chaque lame 24 à 27 a la forme d'un parallélépipède rectangle sur la face supérieure duquel sont gravées des pistes électriques qui seront décrites plus en détail en regard de la figure 3. Sur la face inférieure de chacune de ces lames 24 à 27 est ménagé un groupe, respectivement 30 à 33, de canaux de circulation d'un fluide de refroidissement. Ces canaux traversent de part en part le substrat 22 à partir de la face avant jusqu'à la face arrière du parallélépipède et s'étendent parallèlement aux faces de côté du substrat 22. Ici, chaque groupe comporte huit canaux espacés l'un de l'autre de 2 mm et profond de 0,5 mm.

Ici, des languettes de connexion 36 à 38 raccordées respectivement aux grilles des transistors 4 à 6 font saillies horizontalement vers l'extérieur à partir de la face avant du substrat 22.

La cellule 20 comporte également des languettes 42 et 44 de connexion de puissance respectivement raccordées au collecteur du transistor 6 et à l'émetteur du transistor 4. Ces languettes 42 et 44 font saillie vers l'extérieur à partir de faces opposées du substrat 22, c'est-à-dire ici la face verticale du côté gauche et la face verticale du côté droit du substrat 22.

Les languettes 36 à 38 sont destinées à être raccordées à une unité de commande de la commutation des transistors 4 à 6. Les languettes 42 et 44 sont quant à elles destinées respectivement à être raccordées aux potentiels Vs et Ve.

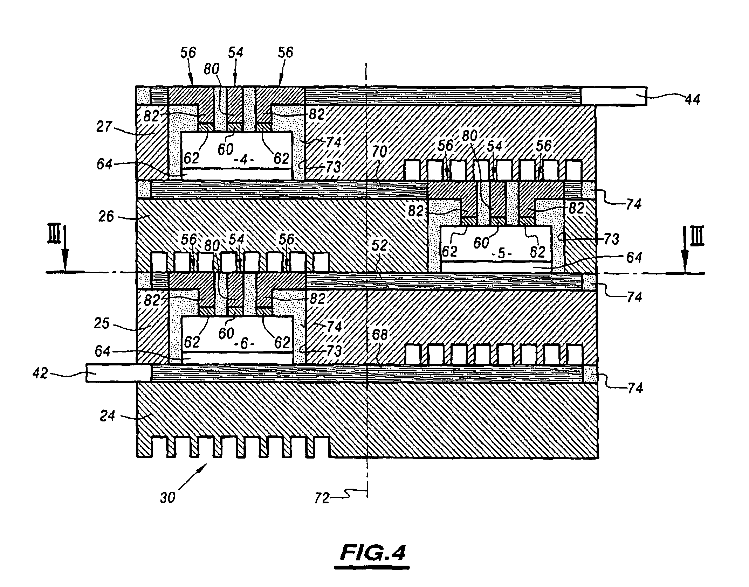

Finalement, interposées entre chaque lame, le substrat 22 comporte des couches de liaison destinées à fixer rigidement les lames les unes aux autres, qui seront décrites de façon plus détaillées en regard de la figure 4.

La figure 3 représente une vue de dessus de la face supérieure de la lame 25.

Les deux carrés en pointillé représentent respectivement l'emplacement où sont incorporés dans cette lame 25 le transistor 6 et la diode anti-parallèle 12.

Sur cette face supérieure, deux pistes électriques 50 et 52, par exemple en cuivre, sont gravées. La piste 50 se prolonge à partir d'un point 54 de connexion à la grille du transistor 6 jusqu'à un point de raccordement avec la languette 36.

La piste 52 est destinée à raccorder l'émetteur du transistor 6 et l'anode de la diode 12 au collecteur du transistor 5 et à la cathode de la diode 11 pour former la connexion intermédiaire 8. A cet effet, la piste 52 s'étend à partir de points 56 de connexion à l'émetteur du transistor 6 et de points 58 de connexion à l'anode de la diode 12. La piste 52 présente par ailleurs, une surface suffisamment étendue pour que le collecteur du transistor 5 puisse être soudé sur celle-ci ainsi que la cathode de la diode 11. La surface de la piste 52 est choisie aussi grande que possible pour diffuser et dissiper la chaleur du transistor 5.

De façon similaire à ce qui a été décrit pour la lame 25, des pistes électriques sont gravées sur chacune des faces supérieures des lames 24, 26 et 27 de manière à former les connexions électriques de la chaîne 2. Ces pistes électriques seront décrites plus en détail en regard de la figure 4.

La figure 4 représente une coupe verticale selon la ligne IV-IV du substrat 22.

Dans la structure de la cellule 1, chaque transistor 4, 5, 6 est incorporé dans une lame en matériau diélectrique, par exemple en mettant en oeuvre le procédé décrit dans l'article du CPES précédemment référencé.

Les composants de puissance incorporés dans ces lames présentent chacun une face supérieure et une face inférieure équipées de bornes de connexion respectives. Par exemple, dans le cas des transistors 4, 5 et 6, la face supérieure comporte une borne 60 de connexion à la grille du transistor et six bornes 62 de connexion à l'émetteur du transistor. Sur cette vue en coupe, seules deux bornes 62 sont visibles pour chaque transistor.

La face inférieure de chaque transistor comporte une borne 64 de connexion du collecteur du transistor s'étendant sensiblement sur toute la surface inférieure du transistor.

De façon similaire les diodes 10 à 12 se présentent sous la forme d'un composant présentant une face supérieure portant trois bornes de connexion de l'anode et une face inférieure portant une borne de connexion de la cathode (non représentée). Seul le raccordement des transistors entre eux est représenté en détail sur la figure 4. Le raccordement des diodes en série est similaire à celui des transistors et se déduit des explications données ci-dessous.

Un transistor et sa diode raccordée en position anti-parallèle incorporés dans une même lame forment un groupe de composants. Ces groupes sont disposés en alternance à droite et à gauche d'un plan vertical médian 72 de manière à ce qu'il soit possible de disposer un groupe de canaux de circulation d'un fluide de refroidissement en dessous de chaque groupe successif dans la chaîne 2. Le plan 72 est perpendiculaire au plan de la figure 4. Ici, les transistors 4 et 6 sont disposés à gauche de ce plan tandis que le transistor 5 est disposé à droite.

Sur la face supérieure de la lame 24 est gravée une piste électrique 68 sur laquelle le collecteur 64 du transistor 6 et la cathode de la diode 12 sont brasés. Cette piste 68 est également raccordée par brasage ou soudure à la languette 42.

Aucun composant de puissance n'est incorporé dans cette lame 24 située à l'extrémité inférieure de l'empilement.

Le collecteur 64 du transistor 5 et la cathode de la diode 11 sont brasés sur la piste 52 de la lame 25 à droite du plan 72.

Le collecteur 64 du transistor 4 et la cathode de la diode 10 sont brasés sur une piste 70 gravée sur la face supérieure de la lame 26. La face supérieure de la lame 26 est le symétrique de la face supérieure de la lame 25 par rapport au plan 72 de telle sorte que la piste 70 forme la connexion intermédiaire 7.

La face supérieure de la lame 27 située à l'extrémité supérieure de l'empilement est identique à celle de la lame 26 à l'exception du fait que la piste raccordée à l'émetteur du transistor 4 est également raccordée à la languette 44 et qu'aucun transistor ou diode n'est brasé sur cette face.

Chaque groupe de canaux 30 à 33 est ici creusé dans la lame correspondante à partir de la face inférieure de celle-ci située juste en dessous de l'endroit où sont soudés sur sa face supérieure le transistor et la diode.

A titre d'illustration, les lames 24 à 27 sont toutes d'épaisseur constante égale à 1 millimètre ou plus et les transistors 4 à 6 sont tous identiques et présentent une épaisseur d'environ 500 micromètres. L'épaisseur des pistes 52, 68 et 70 est ici de 100 micromètres.

Chaque transistor et diode sont logés dans des trous 73 respectifs traversant la lame dans laquelle ils sont incorporés. A l'intérieur de leurs trous respectifs, le transistor et la diode sont disposés de manière à ce que la borne 64, respectivement la cathode, affleure parallèlement à la face inférieure de cette lame. Au contraire, les bornes 60 et 62 du transistor, respectivement l'anode de la diode, sont situées dans un plan parallèle à la face supérieure mais situé en dessous du niveau de la face supérieure de manière à ce que les bornes 60 et 62 ainsi que l'anode soient entièrement incorporées à l'intérieur de la lame. Les transistors et les diodes sont fixés dans cette position à l'aide d'une résine isolante 74 disposée entre la surface extérieure du transistor et de la diode et la surface intérieure des trous 73 dans lesquels ils sont logés.

Cette résine isolante 74 est également répandue entre deux lames successives de l'empilement de manière à isoler électriquement les pistes 52, 68 et 70 ainsi que les points de connexion 54, 56 de l'environnement extérieur. En particulier, ce dépôt de résine isolante assure l'isolation électrique entre les points de connexion 54 et 56 et les groupes de canaux de circulation de fluide de refroidissement.

Pour chaque transistor et diode incorporés dans une lame, les points de connexion 54, 56 et 58 sont formés par un dépôt de matériau conducteur entre d'une part les bornes de connexion sur la face supérieure du transistor ou de la diode et d'autre part les pistes correspondantes gravées sur la face supérieure de cette lame.

Chaque point de connexion comporte une portion rectiligne verticale correspondant à un puits rempli de matériau conducteur. Ici, un puits 82 est formé entre la face supérieure de la lame dans laquelle est incorporée un transistor et les bornes de connexion 62 de ce transistor. De façon similaire, un puits 80 est formé entre la face supérieure de chaque lame incorporant un transistor et la borne de connexion 60 de la grille de ce transistor.

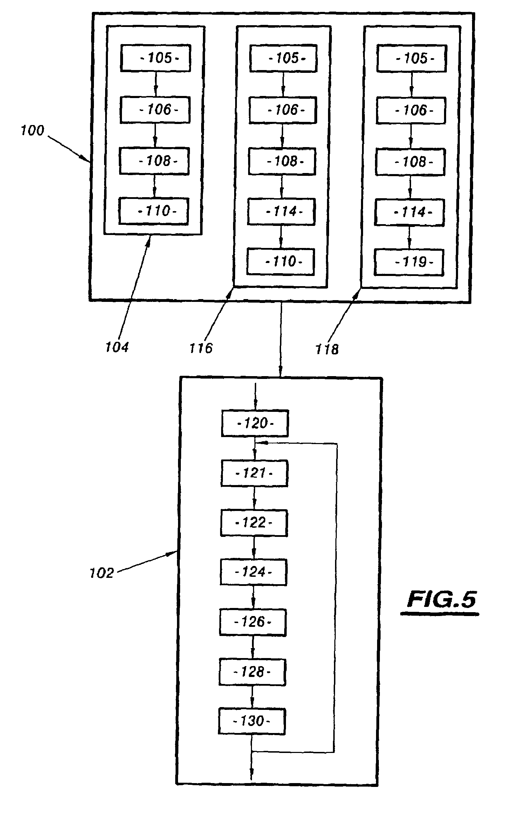

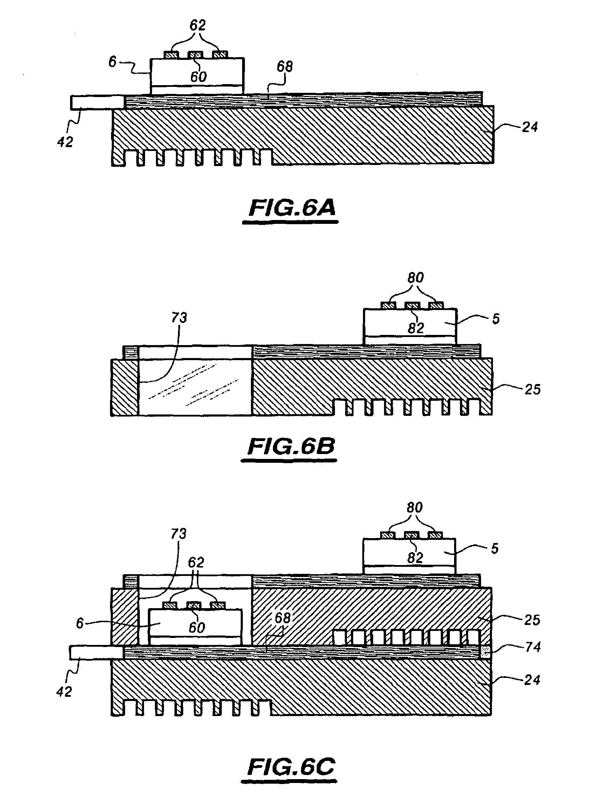

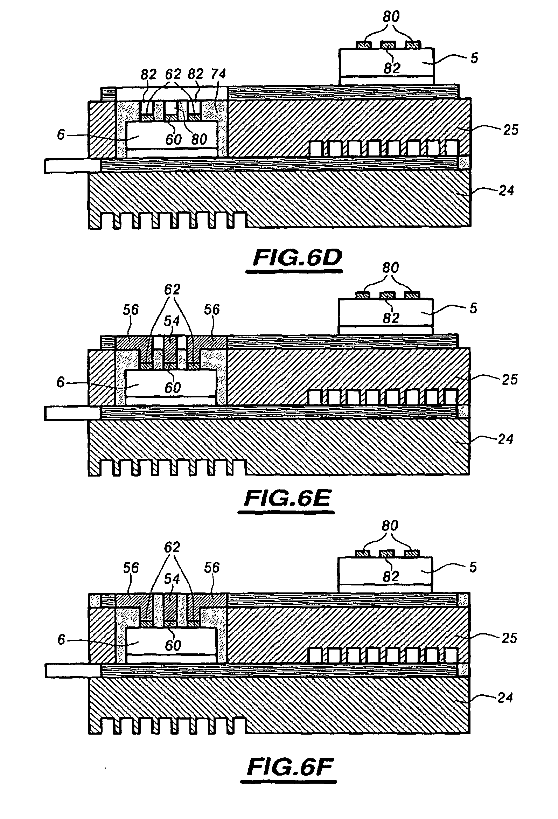

Un procédé de fabrication de la cellule de commutation 20 va maintenant être décrit en regard du procédé de la figure 5 et des figures 6A à 6F dans le cas particulier d'une cellule de commutation comportant trois transistors raccordés en série.

Le procédé se déroule en deux phases principales. Tout d'abord une phase 100 de fabrication de blocs élémentaires standards suivie d'une phase 102 d'assemblage de ces blocs élémentaires pour former la cellule 20.

Lors de la phase 100 des blocs de base correspondant à la lame 24 associée au transistor 6 et à la diode 12, sont fabriqués lors d'une étape 104.

Lors de cette étape 104, un support conventionnel de composants électriques est découpé, lors d'une opération 105, à un format standard. Un tel support conventionnel se présente sous la forme d'une couche en matériau diélectrique présentant une face supérieure cuivrée destinée à être gravée. Ensuite, le groupe 30 de canaux est creusé, lors d'une opération 106, sur la face inférieure du support.

La surface cuivrée de la plaque est gravée, lors d'une opération 108, pour former la piste 68 et le transistor 6 et la diode 12 sont brasés lors d'une opération 110 sur la piste 68. Lors de l'opération 110, la languette 42 est également soudée avec la piste 68.

A l'issue de ces opérations 106 à 110, la brique de base représentée en coupe longitudinale sur la figure 6A est obtenue.

Simultanément à cette étape 104, une étape 116 de fabrication de briques intermédiaires est réalisée. Cette étape 116 comporte les mêmes opérations que l'étape 104 ainsi qu'une opération supplémentaire 114 consistant à découper dans le support les deux trous 73 destinés chacun à recevoir un transistor ou une diode. Ces trous traversent de part en part l'épaisseur du support et sont ménagés du côté opposé à celui où le transistor et la diode sont brasés. Lors de l'opération 110 de l'étape 116, aucune languette 42 n'est soudée.

Ainsi, à l'issue de l'étape 116, on obtient une brique intermédiaire représentée sur la figure 6B correspondant par exemple à la lame 25 associée au transistor 5 de la figure 4.

Egalement en parallèle aux étapes 104 et 116, une étape 118 de fabrication de briques d'extrémité destinées à être placées à l'extrémité supérieure de l'empilement de lames est réalisée. Cette étape 118 est identique à l'étape 104 à l'exception du fait que l'étape 110 est remplacée par l'étape 114 et qu'une opération 119 de raccordement de la languette de connexion 44 est réalisée. A l'issue de cette étape 118, une brique d'extrémité similaire à la lame 27 associée à la languette 44 est obtenue.

Lors de cette phase 100 une grande quantité de briques élémentaires sont fabriquées et stockées sans présager, à ce stade-là de la fabrication, si ces briques élémentaires seront ensuite utilisées pour fabriquer des cellules de commutation comportant 2, 3, 4 ou plus, transistors en série.

Lors de la phase 102, une couche de la résine isolante 74 est déposée, lors d'une étape 120, sur la face supérieure de la brique de base de manière à isoler électriquement la piste 68 de l'environnement extérieur. En particulier, cette couche est destinée à isoler électriquement la piste 68 du groupe de canaux 31.

Une fois cette étape 120 terminée, de la colle (non représentée) est répartie lors d'une étape 121, sur la face supérieure de la brique de base. Cette colle est disposée de manière à assurer la fixation sur cette face supérieure d'une brique intermédiaire.

Ensuite, une brique intermédiaire est empilée, lors d'une étape 122, sur la brique de base de telle sorte que le transistor brasé sur la brique de base soit logé à l'intérieur du trou 73 ménagé dans la brique intermédiaire.

A l'issue de l'étape 122, l'assemblage de la figure 6C est obtenu, cet assemblage correspondant par exemple à l'empilement de la lame 25 sur la lame 24.

La résine 74 en matériau diélectrique isolant, tel qu'une résine époxy, est déposée, lors d'une étape 124, à l'intérieur du trou 73 dans lequel est logé le transistor 6 pour isoler électriquement ce dernier de son environnement puis, lors d'une étape 126, les puits 80 et 82 sont creusés dans la résine isolante. Cette étape 126 est par exemple réalisée par un procédé de sérigraphie ou un procédé connu sous le terme anglais de « dispensing ». L'assemblage obtenu à l'issue de cette étape 126 est celui de la figure 6D.

Du cuivre est ensuite déposé, lors d'une étape 128, dans les puits 80 et 82 ainsi que sur la face supérieure de la lame 25 de manière à former les points de connexion 54, 56 et 58 avec les pistes correspondantes gravées sur la face supérieure de la lame 25. Le résultat obtenu à l'issue de cette étape est représenté sur la figure 6E.

Finalement, lors d'une étape 130, une nouvelle couche de la résine 74 est répandue sur la face supérieure de la lame 25 de manière à isoler les pistes et points de connexions électriques et à assurer la planéité de la face supérieure de l'empilement destiné à recevoir la brique suivante.

A l'issue de l'étape 130, les étapes 121 à 130 sont réitérées dans le cas particulier de l'empilement d'une nouvelle brique intermédiaire sur celles déjà empilées. Les étapes 121 à 130 sont donc réitérées autant de fois qu'il y a de composants dans la chaîne 2, c'est-à-dire ici trois fois en tout. On notera cependant que lors de la dernière itération des étapes 121 à 130, ce n'est pas une brique intermédiaire qui est empilée de façon similaire à ce qui a été décrit en regard des étapes 121 à 130 mais une brique d'extrémité.

Ainsi, grâce à ce procédé, des briques élémentaires peuvent être fabriquées et stockées sans présager à l'avance de leur utilisation.

Une cellule de commutation fabriquée par exemple selon le procédé de la figure 5 présente également l'avantage d'avoir des groupes de canaux de circulation de fluide de refroidissement ménagés en dessus et en dessous de chaque composant de puissance de sorte que ces composants de puissance sont refroidis à la fois par leur face inférieure et leur face supérieure. Grâce à cela, le refroidissement des composants de puissance est plus efficace et les performances électriques de la cellule s'en trouvent améliorées.

La cellule 20 a été décrite ici dans le cas particulier où les connexions intermédiaires 7 et 8 ne sont pas accessibles à partir de l'extérieur du substrat 22. Toutefois, en variante, de façon similaire à ce qui a été décrit pour le raccordement à la grille du transistor, pour chaque connexion intermédiaire, une languette faisant saillie sur la face arrière du substrat 22 est raccordée à cette connexion intermédiaire. Une telle variante est particulièrement avantageuse lorsque la cellule comporte un nombre pair de transistors en série et lorsque cette languette supplémentaire est raccordée à la connexion intermédiaire située au milieu de la chaîne de manière à former un point milieu. Une telle cellule de commutation forme alors à elle seule un bras d'un onduleur.

La cellule 20 a été décrite ici dans le cas particulier où les composants de puissance sont formés de diodes et de transistors. Toutefois, en variante, ces composants peuvent être remplacés par d'autres composants propres à commuter des courants ou des tensions tels que par exemple des thyristors.

## Revendications

1. Cellule de commutation de puissance comportant au moins deux composants de puissance (4-6) incorporés dans un substrat diélectrique (22) et présentant chacun une première face équipée d'au moins une borne de connexion électrique (64) et une seconde face opposée équipée d'au moins une autre borne de connexion électrique (60, 62), ces composants (4-6) formant une chaîne (2) de composants électriquement raccordés en série par l'intermédiaire d'au moins une connexion intermédiaire (7, 8) entièrement incorporée à l'intérieur dudit substrat (22), chaque connexion intermédiaire reliant électriquement la seconde face du composant précédent à la première face du composant suivant dans ladite chaîne (2), les faces non raccordées à une connexion intermédiaire (7, 8) des composants situés aux extrémités de ladite chaîne étant disposées de manière à être séparées l'une de l'autre par l'intermédiaire du matériau diélectrique formant ledit substrat (22), **caractérisée en ce que** le substrat (22) est formé d'un empilement de lames parallèles (24-27) en matériau diélectrique, et **en ce que** chacun des composants (4-6) se suivant dans ladite chaîne (2) est incorporé dans l'épaisseur d'une lame différente.

2. Cellule selon la revendication 1, **caractérisée en ce que** les faces non raccordées à une connexion intermédiaire (7, 8) des composants situés aux extrémités de la dite chaîne (2) sont tournées dans des directions différentes de manière à ce que le plus court chemin entre ces deux faces traverse le matériau diélectrique formant ledit substrat (22) dans lequel ils sont incorporés.

3. Cellule selon la revendication 1, **caractérisée en ce que** les première et seconde faces de chaque composant (4-6) sont parallèles aux faces de la lame dans laquelle le composant est incorporé.

4. Cellule selon la revendication 3, **caractérisée en ce que** au moins l'une des première et seconde faces de chaque composant (4-6) affleure d'un côté de la lame dans laquelle le composant est incorporé.

5. Cellule selon l'une quelconque des revendications 1 à 4, **caractérisée en ce que** ladite connexion intermédiaire (7, 8) entre deux composants est formée par une piste électrique (52, 70) gravée sur au moins l'une des faces de la lame dans laquelle l'un de ces deux composants est incorporé.

6. Cellule selon la revendication 5, **caractérisée en ce que** au moins l'un des deux composants (4, 5) de ladite chaîne est soudé sur ladite piste électrique gravée (52, 70).

7. Cellule selon une quelconque des revendications précédentes, **caractérisée en ce qu'**elle comporte au moins un canal (30 à 33) de circulation d'un fluide de refroidissement ménagé à l'intérieur dudit substrat pour refroidir au moins l'un des composants incorporés dans ce substrat.

8. Cellule selon la revendication 7, **caractérisée en ce qu'**elle comporte plusieurs canaux de circulation d'un fluide de refroidissement, et **en ce que** chaque composant de puissance est interposé entre au moins deux de ces canaux de manière à ce que sa première et sa seconde face soient refroidies par ces canaux.

9. Cellule selon les revendications 1 et 8 prises ensemble, **caractérisée en ce qu'**elle comporte au moins un canal (30 à 33) de circulation d'un fluide de refroidissement ménagé dans chaque lame (24 à 27) formant ledit substrat.

10. Cellule selon les revendications 6 et 9 prises ensemble, **caractérisée en ce que** ledit au moins un canal (30 à 33) ménagé dans chaque lame est situé en dessous du ou de chaque composant soudé sur la face de cette lame.

11. Cellule selon l'une des revendications précédentes, **caractérisée :**
- **en ce que** le substrat (22) présente au moins une première et une deuxième faces opposées,
- **en ce que** la cellule comporte une languette (42) de connexion électrique raccordée à la première face du premier composant (6), de ladite chaîne 2 et une deuxième languette (44) de connexion électrique raccordée à la seconde face du dernier composant (4) de la dite chaîne (2), et
- **en ce que** les première et deuxième languettes (42, 44) sont en saillie respectivement sur les première et seconde faces opposées.

12. Cellule selon la revendication 11, **caractérisée :**
- **en ce que** le substrat (22) présente une troisième face différente des première et deuxième faces,
- **en ce que** la cellule comporte au moins une troisième languette de connexion électrique raccordée à une connexion intermédiaire (7, 8) et
- **en ce que** cette troisième languette est en saillie à partir de la troisième face.

13. Cellule selon l'une quelconque des revendications précédentes, **caractérisée en ce que** les composants sont des transistors de puissance.

14. Cellule selon l'une quelconque des revendications précédentes, **caractérisée en ce que** le substrat est de forme parallélépipédique.

15. Cellule selon l'une quelconque des revendications précédentes, **caractérisée en ce que** les lames (24 à 27), incorporant les composants sont toutes de taille identique.

16. Procédé de fabrication d'une cellule de commutation conforme à l'une quelconque des revendications précédentes, **caractérisé en ce qu'**il comporte :
- une phase (100) de fabrication de blocs élémentaires, chaque bloc élémentaire étant formé d'une lame (25 à 26) du substrat sur laquelle est soudé l'un des composants de puissance (4 à 7) et dans laquelle est ménagé un trou (73) traversant destiné à recevoir le composant de puissance d'un autre bloc élémentaire identique, et
- une phase (102) d'assemblage lors de laquelle les blocs élémentaires sont empilés les uns sur les autres pour former ladite cellule de commutation.

## Claims

1. Power switching cell comprising at least two power components (4-6) incorporated into a dielectric substrate (22) and each having a first face fitted with at least one electrical connection terminal (64) and an opposing second face fitted with at least another electrical connection terminal (60, 62), wherein these components (4-6) form a chain (2) of components connected electrically in series by means of at least one intermediate connection (7, 8) completely incorporated inside said substrate (22), and each intermediate connection electrically connects the second face of the component preceding the following first face of the component in said chain (2), wherein the faces not connected to an intermediate connection (7, 8) of the components located at the ends of said chain are arranged so that they are separated from one another by means of the dielectric material forming said substrate (22), **characterised in that** the substrate (22) is formed from a stack of parallel plates (24-27) of dielectric material, and **in that** each of the components (4-6) following in said chain (2) is incorporated into the thickness of a different plate.

2. Cell according to claim 1, **characterised in that** the faces not connected to an intermediate connection (7, 8) of the components located at the ends of said chain (2) are directed towards different directions so that the shortest path between these two faces passes through the dielectric material forming said substrate (22), in which they are incorporated.

3. Cell according to claim 1, **characterised in that** the first and second faces of each component (4-6) are parallel to the faces of the plate, in which the component is incorporated.

4. Cell according to claim 3, **characterised in that** at least one of the first and second faces of each component (4-6) are flush with one side of the plate, in which the component is incorporated.

5. Cell according to any one of claims 1 to 4, **characterised in that** said intermediate connection (7, 8) between two components is formed by an electrical conductor track (52, 70) engraved on at least one of the faces of the plate, in which one of these two components are incorporated.

6. Cell according to claim 5, **characterised in that** at least one of the two components (4, 5) is welded onto said engraved electrical conductor track (52, 70).

7. Cell according to any one of the preceding claims, **characterised in that** it comprises at least one cooling fluid duct (30 to 33) arranged inside said substrate to cool at least one of the components incorporated into this substrate.

8. Cell according to claim 7, **characterised in that** it comprises a plurality of cooling fluid ducts, and **in that** each power component is interposed between at least two of these ducts so that its first and its second face are cooled by these ducts.

9. Cell according to claims 1 and 8 taken in combination, **characterised in that** it comprises at least one cooling fluid duct (30 to 33) arranged in each plate (24 to 27) forming said substrate.

10. Cell according to claims 6 and 9 taken in combination, **characterised in that** said at least one duct (30 to 33) arranged in each plate is located below the or each component welded onto the face of this plate.

11. Cell according to one of the preceding claims, **characterised**
• **in that** the substrate (22) has at least one first and one second opposing face,
• **in that** the cell comprises an electrical connection lug (42) connected to the first face of the first component (6) of said chain (2) and a second electrical connection lug (44) connected to the second face of the last component (4) of said chain (2), and
• **in that** the first and second lugs (42, 44) respectively project on the first and second opposing faces.

12. Cell according to claim 11, **characterised**
• **in that** the substrate (22) has a third face differing from the first and second faces,
• **in that** the cell comprises at least a third electrical connection lug connected to an intermediate connection (7, 8), and
• **in that** this third lug projects from the third face.

13. Cell according to any one of the preceding claims, **characterised in that** the components are power transistors.

14. Cell according to any one of the preceding claims, **characterised in that** the substrate is cuboidal.

15. Cell according to any one of the preceding claims, **characterised in that** the plates (24, to 27) incorporating the components are all identical in size.

16. Method for producing a switching cell according to any one of the preceding claims, **characterised in that** it comprises:
• a phase (100) of producing base blocks, wherein each base block is formed from a plate (25 to 26) of the substrate, on which one of the power components (4 to 7) is welded and in which a through-hole (73) is arranged for the purpose of receiving the power component of another identical base block, and
• an assembly phase (102), in which the base blocks are stacked one on top of the other to form said switching cell.

## Patentansprüche

1. Leistungsschaltungszelle, die aufweist: mindestens zwei Leistungskomponenten (4 bis 6), die in einem dielektrischen Substrat (22) aufgenommen sind und jeweils aufweisen: eine erste Fläche, die mit mindestens einer elektrischen Anschlussklemme (64) versehen ist, und eine zweite entgegengesetzte Fläche, die mit mindestens einer anderen elektrischen Anschlussklemme (60, 62) versehen ist, wobei die Komponenten (4 bis 6) eine Kette (2) von Komponenten bilden, die mittels mindestens einer Zwischenschaltung (7, 8), die vollständig im Inneren des Substrates (22) aufgenommen ist, elektrisch in Reihe geschaltet sind, wobei jede Zwischenschaltung die zweite Fläche der vorangehenden Komponente elektrisch an die erste Fläche der in der Kette (2) folgenden Komponente anschließt, wobei die nicht an eine Zwischenschaltung (7, 8) angeschlossenen Flächen der an den äußeren Enden der Kette positionierten Komponenten derart angeordnet sind, dass sie mittels des dielektrischen Materials, welches das Substrat (22) bildet, voneinander getrennt sind, **dadurch gekennzeichnet, dass** das Substrat (22) aus einem Stapel von parallelen Blättern (24 bis 27) aus einem dielektrischen Material gebildet ist, und dass jede der Komponenten (4 bis 6), die in der Kette (2) aufeinander folgen, in der Dicke eines anderen Blatts aufgenommen ist.

2. Zelle gemäß Anspruch 1, **dadurch gekennzeichnet, dass** die nicht an eine Zwischenschaltung (7, 8) angeschlossenen Flächen der an den äußeren Enden der Kette (2) positionierten Komponenten in unterschiedliche Richtungen ausgerichtet sind, so dass der kürzeste Weg zwischen den beiden Flächen das dielektrische Material durchquert, welches das Substrat (22) bildet, in dem sie aufgenommen sind.

3. Zelle gemäß Anspruch 1, **dadurch gekennzeichnet, dass** die erste und die zweite Fläche jeder Komponente (4 bis 6) parallel zu den Flächen des Blattes sind, in das die Komponente aufgenommen ist.

4. Zelle gemäß Anspruch 3, **dadurch gekennzeichnet, dass** mindestens eine der ersten und der zweiten Fläche jeder Komponente (4 bis 6) auf einer Seite des Blattes, in das die Komponente aufgenommen ist, bündig eingelassen ist.

5. Zelle gemäß einem der Ansprüche 1 bis 4, **dadurch gekennzeichnet, dass** die Zwischenschaltung (7, 8) zwischen zwei Komponenten durch eine elektrische Bahn (52, 70) gebildet ist, die in mindestens eine der Flächen des Blattes, in das die eine der beiden Komponenten aufgenommen ist, eingeätzt ist.

6. Zelle gemäß Anspruch 5, **dadurch gekennzeichnet, dass** mindestens eine der beiden Komponenten (4, 5) der Kette an die eingeätzte elektrische Bahn (52, 70) angeschweißt ist.

7. Zelle gemäß einem der vorhergehenden Ansprüche, **dadurch gekennzeichnet, dass** sie mindestens einen Kanal (30 bis 33) für die Zirkulation einer Kühlflüssigkeit aufweist, der im Inneren des Substrates vorgesehen ist, zum Kühlen von mindestens einer der in dem Substrat aufgenommenen Komponenten.

8. Zelle gemäß Anspruch 7, **dadurch gekennzeichnet, dass** sie mehrere Kanäle für das Zirkulieren einer Kühlflüssigkeit aufweist, und dass jede Leistungskomponente zwischen mindestens zwei der Kanäle angeordnet ist, so dass ihre erste und ihre zweite Fläche durch die Kanäle gekühlt werden.

9. Zelle gemäß den Ansprüchen 1 und 8 in Kombination, **dadurch gekennzeichnet, dass** sie mindestens einen Kanal (30 bis 33) für das Zirkulieren einer Kühlflüssigkeit aufweist, der in jedem Blatt (24 bis 27) ausgebildet ist, welches das Substrat bildet.

10. Zelle gemäß den Ansprüchen 6 und 9 in Kombination, **dadurch gekennzeichnet, dass** der mindestens eine Kanal (30 bis 33), der in jedem Blatt ausgebildet ist, unterhalb der oder jeder auf die Fläche des Blattes geschweißten Komponente positioniert ist.

11. Zelle gemäß einem der vorhergehenden Ansprüche, **dadurch gekennzeichnet, dass**:
- das Substrat (22) mindestens eine erste und eine zweite entgegengesetzte Fläche aufweist,
- die Zelle aufweist: eine elektrische Anschlusslasche (42), die an die erste Fläche der ersten Komponente (6) der Kette (2) angeschlossen ist, und eine zweite elektrische Anschlusslasche (44), die an die zweite Fläche der letzten Komponente (4) der Kette (2) angeschlossen ist, und
- dass die erste und die zweite Lasche (42, 44) jeweils von der ersten und der zweiten entgegengesetzten Fläche hervorstehen.

12. Zelle gemäß Anspruch 11, **dadurch gekennzeichnet, dass**:
- das Substrat (22) eine dritte Fläche aufweist, die sich von der ersten und der zweiten Fläche unterscheidet,
- die Zelle mindestens eine dritte elektrische Anschlusslasche aufweist, die an eine Zwischenschaltung (7, 8) angeschlossen ist, und
- dass die dritte Lasche von der dritten Fläche hervorsteht.

13. Zelle gemäß einem der vorhergehenden Ansprüche, **dadurch gekennzeichnet, dass** die Komponenten Leistungstransistoren sind.

14. Zelle gemäß einem der vorhergehenden Ansprüche, **dadurch gekennzeichnet, dass** das Substrat parallelepipedförmig ist.

15. Zelle gemäß einem der vorhergehenden Ansprüche, **dadurch gekennzeichnet, dass** die Blätter (24 bis 27), die die Komponenten aufnehmen, alle eine identische Größe aufweisen.

16. Verfahren zur Herstellung einer Schaltungszelle gemäß einem der vorhergehenden Ansprüche, **dadurch gekennzeichnet, dass** es aufweist:
- eine Phase (100) der Herstellung von elementaren Blöcken, wobei jeder elementare Block aus einem Blatt (25 bis 26) des Substrats gebildet wird, auf welches eine der Leistungskomponenten (4 bis 7) geschweißt wird, und in welchem ein Durchgangsloch (73) vorgesehen wird, das zum Aufnehmen der Leistungskomponente eines anderen identischen elementaren Blocks bestimmt ist, und
- eine Montage-Phase (102), während der die elementaren Blöcke zum Ausbilden der Schaltungszelle aufeinander gestapelt werden.
